# EUROPEAN PATENT APPLICATION

(11) **EP 1 893 007 A2**
(43) Date of publication of application: **27.02.2008**
(21) Application number: 07253333.4
(22) Date of filing: 23.08.2007
(51) Int. Cl.: H05K 5/02

(54) **Plasma display apparatus**

(30) Priority: 23.08.2006 KR 20060080140
(71) Applicant: LG Electronic Inc., Seoul 150-721 (KR)
(72) Inventor: Cho, Janghwan, Seoul 137-724 (KR); Park, Hyunil, Seoul 137-724 (KR); Park, Changjoon, Seoul 137-724 (KR); Kim, Sunghwan, Seoul 137-724 (KR)
(74) Representative: Camp, Ronald

(57) **Abstract**

A plasma display apparatus includes a plasma display panel including a scan electrode and a sustain electrode, an integrated driver supplying a driving signal to the scan electrode and the sustain electrode, a frame positioned between the plasma display panel and the integrated driver, and a conductive film element. The conductive film element is positioned between the plasma display panel and the frame, and electrically connects the integrated driver to the sustain electrode.

## Description

### BACKGROUND OF THE DISCLOSURE

### Field of the Disclosure

This invention relates to a display apparatus. It more particularly relates to a plasma display apparatus.

### Description of the Related Art

A plasma display apparatus generally includes a plasma display panel displaying an image, and a driver for driving the plasma display panel. The driver is attached to a rear surface of the plasma display panel.

The plasma display panel has the structure in which barrier ribs formed between a front panel and a rear panel form unit discharge cell or discharge cells. Each discharge cell is filled with an inert gas containing a main discharge gas such as neon (Ne), helium (He) or a mixture of Ne and He, and a small amount of xenon (Xe). A pixel includes a red (R) discharge cell, a green (G) discharge cell, and a blue (B) discharge cell.

When the plasma display panel is discharged by a high frequency voltage, the inert gas generates vacuum ultra-violet rays, which thereby cause phosphors formed between the barrier ribs to emit light, thus displaying an image.

The plasma display panel includes a scan electrode, a sustain electrode, and an address electrode. Drivers are connected to the electrodes of the plasma display panel, and supply driving signals to the corresponding electrodes.

The drivers supply the driving signals to the electrodes during the driving of the plasma display panel, and thus an image is displayed on the plasma display panel. Since the plasma display apparatus can be manufactured to be thin and light, it has attracted attention as a next generation display device.

### SUMMARY OF THE DISCLOSURE

In one aspect, a plasma display apparatus comprises a plasma display panel including a scan electrode and a sustain electrode, an integrated driver that supplies a driving signal to the scan electrode and the sustain electrode, a frame positioned between the plasma display panel and the integrated driver, and a conductive film element that is positioned between the plasma display panel and the frame, and electrically connects the integrated driver to the sustain electrode.

In another aspect, a plasma display apparatus comprises a plasma display panel including a scan electrode and a sustain electrode, an integrated driver that supplies a driving signal to the scan electrode and the sustain electrode, a frame positioned between the plasma display panel and the integrated driver, a conductive film element that is positioned on the frame, and electrically connects the integrated driver to the sustain electrode, and a fixing element that is positioned on the frame, and fixes the conductive film element on the frame.

### BRIEF DESCRIPTION OF THE DRAWINGS

The accompanying drawings, which are included to provide a further understanding of the invention and are incorporated on and constitute a part of this specification, illustrate embodiments of the invention and together with the description serve to explain the principles of the invention. In the drawings:

FIG. 1 illustrates a plasma display apparatus according to an exemplary embodiment;

FIG. 2 illustrates a plasma display panel of FIG. 1;

FIG. 3 illustrates a method for representing a gray scale of the plasma display apparatus of FIG. 1;

FIG. 4 illustrates a driving waveform of a plasma display apparatus according to an exemplary embodiment;

FIG. 5 illustrates an implementation of a connection structure between the plasma display panel of FIG. 1 and a driver;

FIG. 6 illustrates another implementation of a connection structure between the plasma display panel of FIG. 1 and a driver; and

FIG. 7 illustrates another implementation of a connection structure between the plasma display panel of FIG. 1 and a driver.

### DETAILED DESCRIPTION OF EMBODIMENTS

A plasma display apparatus comprises a plasma display panel including a scan electrode and a sustain electrode, an integrated driver that supplies a driving signal to the scan electrode and the sustain electrode, a frame positioned between the plasma display panel and the integrated driver, and a conductive film element that is positioned between the plasma display panel and the frame, and electrically connects the integrated driver to the sustain electrode.

The plasma display apparatus may further comprise a conductive layer positioned between the plasma display panel and the frame. The conductive layer may be connected to a conductive film element connected to the sustain electrode and a conductive film element connected to the integrated driver.

The conductive layer may be positioned in an area corresponding to an effective screen of the plasma display panel.

The conductive layer may be a conductive tape.

The conductive layer may be formed by depositing a conductive material on an adhesive sheet.

The integrated driver may supply a sustain signal, that swings between a positive sustain voltage and a negative sustain voltage, to the scan electrode, and supply a ground level voltage to the sustain electrode during a sustain period.

The conductive film elements may be a flexible printed circuit (FPC).

A plasma display apparatus comprises a plasma display panel including a scan electrode and a sustain electrode, an integrated driver that supplies a driving signal to the scan electrode and the sustain electrode, a frame positioned between the plasma display panel and the integrated driver, a conductive film element that is positioned on the frame, and electrically connects the integrated driver to the sustain electrode, and a fixing element that is positioned on the frame, and fixes the conductive film element on the frame.

The frame may adhere to the conductive film element through the fixing element.

The fixing element may include an insulating material.

The fixing element may include an adhesive tape.

The fixing element may be a mold wrapping the conductive film element.

The mold may be formed of plastic.

The integrated driver may supply a sustain signal, that swings between a positive sustain voltage and a negative sustain voltage, to the scan electrode, and supply a ground level voltage to the sustain electrode during a sustain period.

The conductive film element may be a flexible printed circuit (FPC).

Embodiments will be described in a more detailed manner with reference to the attached drawings.

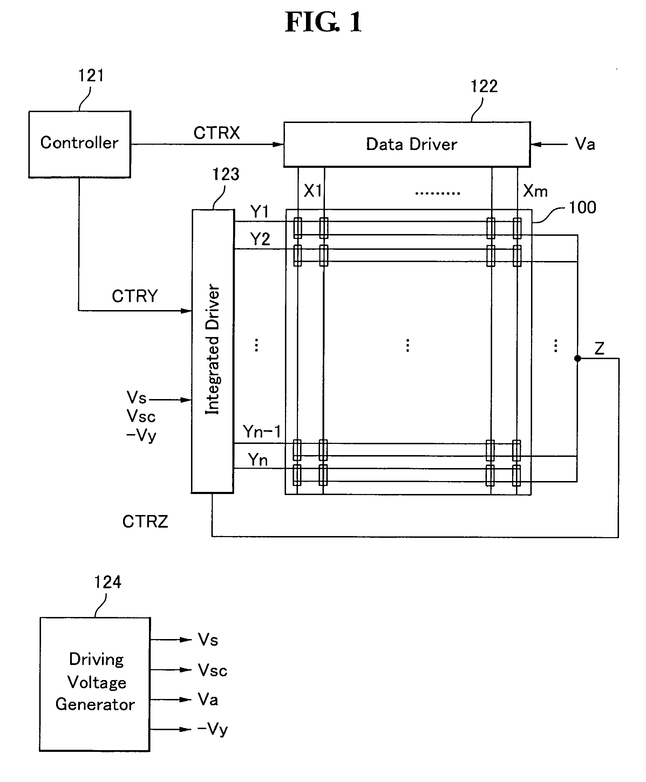

As illustrated in FIG. 1, a plasma display apparatus according to an exemplary embodiment includes a plasma display panel 100, a controller 121, a data driver 122, an integrated driver 123, and a driving voltage generator 124.

The data driver 122 supplies data signals to address electrodes X1 to Xm, and the integrated driver 123 supplies driving signals to scan electrodes Y1 to Yn and sustain electrodes Z.

The plasma display panel 100 includes a front substrate (not shown) and a rear substrate (not shown) that coalesce with each other with a given distance therebetween. On the front substrate, the scan electrodes Y1 to Yn and the sustain electrodes Z are positioned. On the rear substrate, the address electrodes X1 to Xm are positioned to intersect the scan electrodes Y1 to Yn and the sustain electrodes Z.

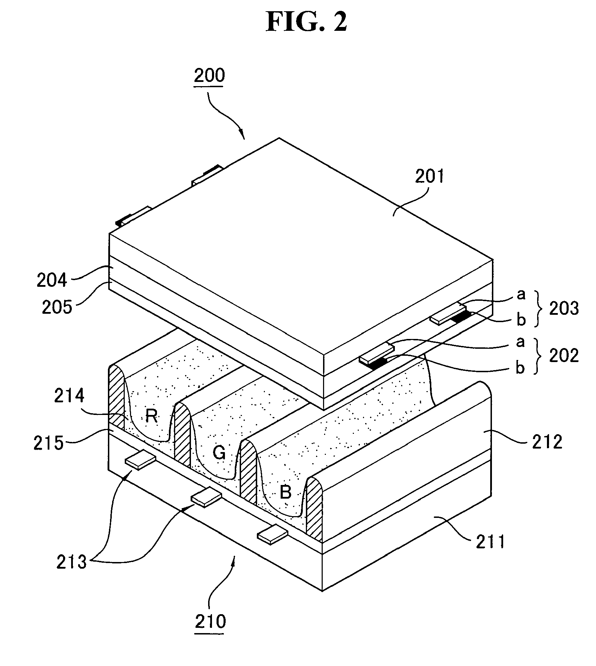

As illustrated in FIG. 2, the plasma display panel includes a front panel 200 and a rear panel 210. A plurality of scan electrodes 202 and a plurality of sustain electrodes 203 are positioned in pairs on a front substrate 201 of the front panel 200. A plurality of address electrodes 213 are positioned on a rear substrate 211 of the rear panel 210 to intersect the scan electrodes 202 and the sustain electrodes 203.

The scan electrode 202 and the sustain electrode 203 each include transparent electrodes 202a and 203a made of a transparent material such as indium-tin-oxide (ITO) and bus electrodes 202b and 203b made of a metal material. The scan electrode 202 and the sustain electrode 203 may include only the bus electrodes 202b and 203b.

An upper dielectric layer 204 covering the scan electrode 202 and the sustain electrode 203 limits a discharge current and provides electrical insulation between the scan electrode 202 and the sustain electrode 203. A protective layer 205 is positioned on the upper dielectric layer 204, and may be MgO capable of facilitating discharge conditions.

A lower dielectric layer 215 positioned on the rear panel 210 covers the address electrode 213 positioned on the rear substrate 211, and provides electrical insulation between the address electrodes 213. Barrier ribs 212 are positioned on the lower dielectric layer 215, and partition each intersection area of the scan and sustain electrodes 202 and 203 and the address electrodes 213. The barrier rib 212 may be formed in a stripe form or a well form. A phosphor 214 is coated between the barrier ribs 212.

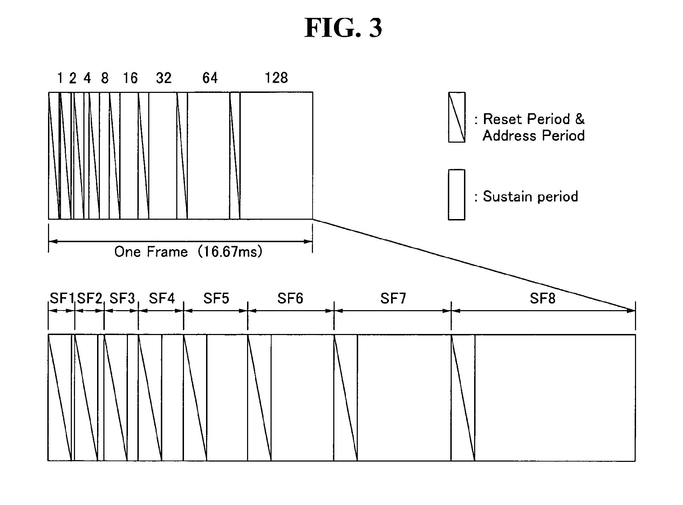

As illustrated in FIG. 3, the plasma display apparatus according to an exemplary embodiment displays a portion of an image during each of a plurality of subfields constituting one frame to display the entire image during one frame. Each subfield includes a reset period during which all discharge cells are initialized, an address period during which cells to be discharged are selected, and a sustain period during which a gray scale of an image is achieved based on the number of discharge operations.

For instance, if an image with a 256-level gray level is to be displayed, a frame period (for instance, 16.67 ms) corresponding to 1/60 sec is divided into eight subfields SF1 to SF8. Each of the eight subfields SF1 to SF8 is subdivided into a reset period, an address period, and a sustain period. In one embodiment the duration of the reset period in a subfield is equal to the durations of the reset periods in the remaining subfields. The duration of the address period in a subfield is equal to the durations of the address periods in the remaining subfields. On the other hand, the duration of the sustain period in a subfield and the number of sustain signals assigned during the sustain period in a subfield may be different in the remaining subfields. For instance, the sustain period may increase in the ratio of 2ⁿ (where, n = 0, 1, 2, 3, 4, 5, 6, 7) in each subfield.

Under the control of the controller 121, the integrated driver 123 of FIG. 1 supplies a reset signal to the scan electrodes Y1 to Yn during a reset period to initialize a state of wall charges distributed in all the discharge cells.

Under the control of the controller 121, the integrated driver 123 supplies a scan reference voltage Vsc and a scan signal with a scan voltage -Vy to the scan electrodes Y1 to Yn during an address period.

Under the control of the controller 121, the integrated driver 123 supplies a sustain signal to the scan electrodes Y1 to Yn during a sustain period. The integrated driver 123 alternately supplies a positive sustain voltage Vs and a negative sustain voltage -Vs to the scan electrodes Y1 to Yn during the sustain period, thereby generating a sustain discharge.

The data driver 122 receives data mapped for each subfield by a subfield mapping circuit (not shown) after being inverse-gamma corrected and error-diffused through an inverse gamma correction circuit (not shown) and an error diffusion circuit (not shown), or the like. The data driver 122 samples and latches the mapped data in response to a timing control signal CTRX supplied from the controller 121, and then supplies a data signal corresponding to the latched data to the address electrodes X1 to Xm. Cells to be discharged during the sustain period are selected based on the data signal.

The controller 121 receives a vertical/horizontal synchronization signal and a clock signal, and generates timing control signals CTRX, CTRY and CTRZ for controlling the operation timing and synchronization of each driver 122 and 123. The controller 121 supplies the timing control signals CTRX, CTRY and CTRZ to the corresponding drivers 122 and 123 to control each of the drivers 122 and 123.

The data control signal CTRX includes a sampling clock for sampling data, a latch control signal, and a switch control signal for controlling the on/off time of an energy recovery circuit and a driving switch element inside the data driver 122. The scan control signal CTRY includes a switch control signal for controlling the on/off time of a sustain driving circuit and a driving switch element inside the integrated driver 123.

The driving voltage generator 124 generates driving voltages necessary to drive the plasma display panel such as a scan reference voltage Vsc, a scan voltage -Vy, a sustain voltage Vs, and a data voltage Vd. These driving voltages may vary in accordance with the composition of a discharge gas or the structure of the discharge cells.

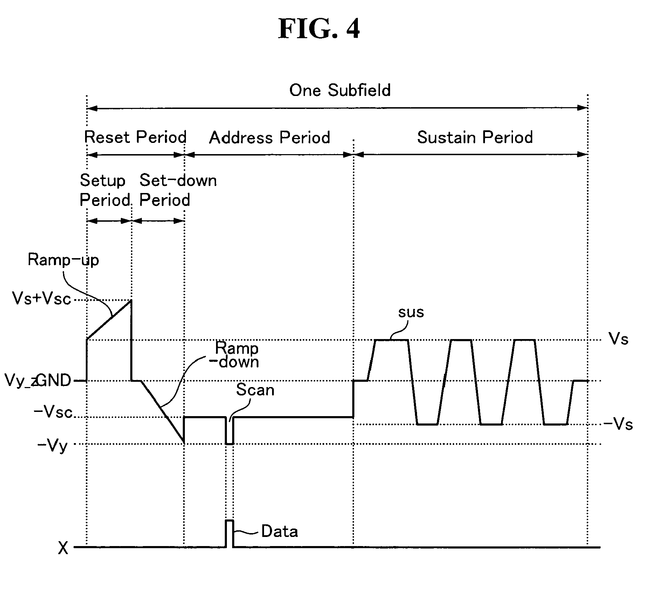

As illustrated in FIG. 4, during a setup period of a reset period, the integrated driver 123 supplies a rising signal (Ramp-up) to the scan electrode Y. Since the rising signal (Ramp-up) generates a weak discharge inside the discharge cells of the entire screen, wall charges are distributed inside the discharge cells. The highest voltage of the rising signal (Ramp-up) may be a sum of the sustain voltage Vs and the scan reference voltage Vsc.

During a set-down period of the reset period, the integrated driver 123 supplies a falling signal (Ramp-down) to the scan electrode Y. Since the falling signal (Ramp-down) generates a weak erase discharge inside the discharge cells, wall charges excessively accumulated inside the discharge cells are erased. Accordingly, the state of wall charges distributed inside all the discharge cells is uniform.

During an address period, the integrated driver 123 supplies a scan signal (Scan) with a voltage -Vy to the scan electrode Y, and the data driver 122 supplies a data signal (Data) to the address electrode X. As the voltage difference between the scan signal (Scan) and the data signal (Data) is added to the wall voltage produced during the reset period, the cells to be discharged are selected and an address discharge occurs inside the selected discharge cells.

During a sustain period, the integrated driver 123 supplies a sustain signal (SUS), that swings between a positive sustain voltage Vs and a negative sustain voltage -Vs, to the scan electrode Y. The integrated driver 123 supplies a ground level voltage GND to the sustain electrode Z. Accordingly, a sustain discharge occurs inside the discharge cells where the address discharge occurs, and thus an image is displayed on the plasma display panel.

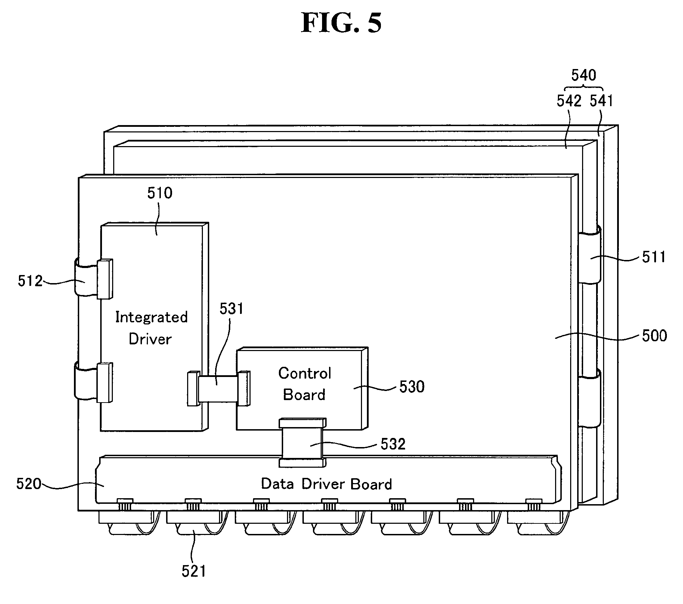

As illustrated in FIG. 5, the plasma display apparatus according to an exemplary embodiment includes a plasma display panel 540, a frame 500 positioned on a rear surface of the plasma display panel 540, and an integrated driver 510, a data driver board 520, a control board 530, and a power supply board (not shown) positioned on the frame 500.

The integrated driver 510 includes one driving board, and can supply driving signals to the scan electrode Y and the sustain electrode Z. In other words, since two types of electrodes can be driven using one driving board, the fabrication cost is reduced. Since a circuit configuration of the integrated driver 510 is simplified, the operation reliability of the integrated driver 510 is improved.

The integrated driver 510 is electrically connected to the sustain electrode Z through conductive film elements 511 and 512. The conductive film elements 511 and 512 electrically connect the integrated driver 510 to the sustain electrode Z by passing through the plasma display panel 540 and the frame 500. One end of each of the conductive film elements 511 and 512 is connected to the integrated driver 510, and the other end is connected to the sustain electrode Z. The conductive film elements 511 and 512 may include a flexible printed circuit (FPC).

As above, since the conductive film elements 511 and 512 connect with the integrated driver 510 and the sustain electrode Z, an electromagnetic interference (EMI) phenomenon can be prevented and the operation reliability of the integrated driver 510 can be improved.

The data driver board 520 supplies the data signal to the address electrode X of the plasma display panel 540 through a film element 521. The film element 521 may be formed in the form of a chip-on film (COF) or a tape carrier package (TCP) having interconnections.

The control board 530 generates timing control signals for controlling the integrated driver 510 and the data driver board 520. More specifically, the control board 530 supplies a timing control signal for the scan electrode Y and a timing control signal for the sustain electrode Z to the integrated driver 510 through a conductive film element 531. Further, the control board 530 supplies a timing control signal for the address electrode X to the data driver board 520 through a conductive film element 532.

The power supply board (not shown) supplies a power supply to each of the integrated driver 510, the data driver board 520, and the control board 530.

The integrated driver 510, the data driver board 520, the control board 530, and the power supply board are fixed on the frame 500 using a plurality of bosses (not shown).

The frame 500 is positioned to overlap the rear surface of the plasma display panel 540, thereby emitting heat generated in the plasma display panel 540 and the integrated driver 510, the data driver board 520, and the control board 530 to the outside. Further, the frame 500 severs as a ground part of each of the integrated driver 510, the data driver board 520, and the control board 530, thereby stabilizing the driving of the plasma display apparatus.

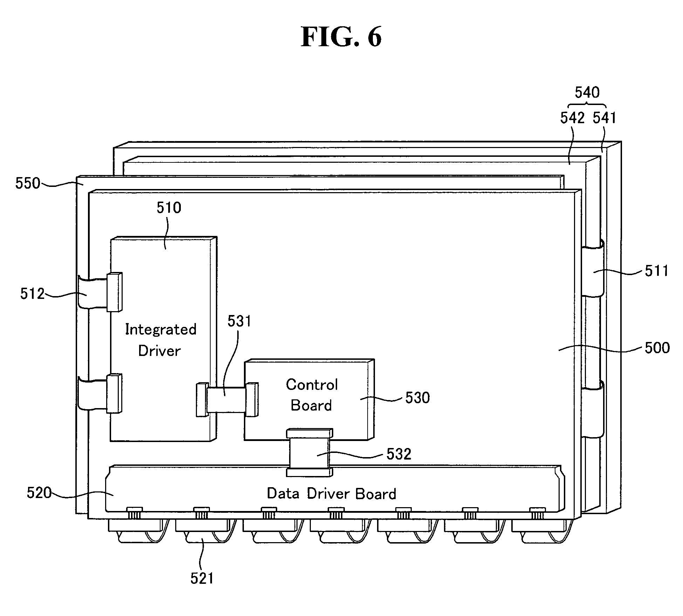

As illustrated in FIG. 6, the plasma display apparatus according to an exemplary embodiment further includes a conductive layer 550, which is attached to the rear surface of the plasma display panel 540, between the plasma display panel 540 and the frame 500. Double-sided insulating tape (not shown) for providing insulation between the conductive layer 550 and the frame 500 may be positioned between the conductive layer 550 and the frame 500.

The conductive layer 550 is connected to the conductive film element 511 connected to the sustain electrode Z, and the conductive film element 512 connected to the integrated driver 510. For instance, one end of the conductive layer 550 is connected to the conductive film element 511 connected to the sustain electrode Z, and the other end is connected to the conductive film element 512 connected to the integrated driver 510. Hence, the conductive layer 550 electrically connects the integrated driver 510 to the sustain electrode Z.

The conductive layer 550 may be positioned in an area corresponding to an effective screen of the plasma display panel 540. Discharge cells capable of emitting light are positioned in the corresponding area of the effective screen. When the conductive layer 550 is positioned in the corresponding area of the effective screen, the conductive layer 550 is an equipotential surface. Accordingly, a difference between brightness of an image displayed on the effective screen is prevented. The conductive layer 550 may include a conductive tape. The conductive layer 550 may be formed by depositing a conductive material on an adhesive sheet.

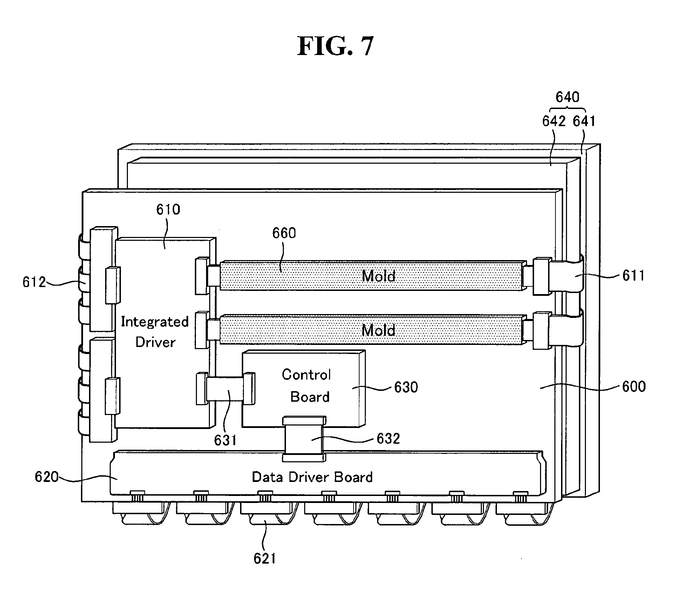

As illustrated in FIG. 7, the plasma display apparatus according to an exemplary embodiment includes a plasma display panel 640, a frame 600 positioned on a rear surface of the plasma display panel 640, and an integrated driver 610, a data driver board 620, a control board 630, and a power supply board (not shown) positioned on the frame 600. The plasma display panel 640 is formed by coalescing a front panel 641 and a rear panel 642 to each other, and displays an image.

The integrated driver 610 includes one driving board, and can supply driving signals to the scan electrode Y and the sustain electrode Z. In other words, since two types of electrodes can be driven using one driving board, the fabrication cost is reduced. Since a circuit configuration of the integrated driver 610 is simplified, the operation reliability of the integrated driver 610 is improved.

The integrated driver 610 is electrically connected to the sustain electrode Z through a conductive film element 611. One end of the conductive film element 611 is connected to the integrated driver 610, and the other end is connected to the sustain electrode Z through the frame 600. The conductive film element 611 may include a flexible printed circuit (FPC). A reference numeral 612 indicates a conductive film element connecting the scan electrode Y to the integrated driver 610.

A fixing element 660 for fixing the conductive film element 611 may be positioned on the frame 600. In other words, since the conductive film element 611 electrically connecting the sustain electrode Z to the integrated driver 610 is electrically insulated from the frame 600, the fixing element 660 capable of fixing the conductive film element 611 on the frame 600 may be positioned.

The fixing element 660 may include an adhesive tape. In other words, while the conductive film element 611 is electrically insulated from the frame 600 by attaching an adhesive tape to a passage of the conductive film element 611 formed by connecting the sustain electrode to the integrated driver 610, the conductive film element 611 can adhere closely to the frame 600.

The fixing element 660 may be a mold wrapping the conductive film element 611. More specifically, the conductive film element 611 connects the sustain electrode to the integrated driver 610 by enabling the conductive film element 611 to pass inward of the mold 660. The mold 660 is made of an insulating material, and can insulate the conductive film element 611 from the frame 600. Further, the mold 660 may be formed of plastic.

As above, since the conductive film element 611 is fixed on the frame 600 using the fixing element 660, the sustain electrode is stably connected to the integrated driver 610 and a driving characteristic is improved. Further, the fixing element 660 can reduce noise caused by a vibration of the conductive film element 611, and can increase the driving stability by serving as a buffer element.

The connection structures of the implementations illustrated in FIGs. 5 to 7 can increase the work efficiency on a process, and can reduce the fabrication cost.

The data driver board 620 supplies the data signal to the address electrode X of the plasma display panel 640 through a film element 621. The film element 621 may be formed in the form of a chip-on film (COF) or a tape carrier package (TCP) having interconnections.

The control board 630 generates timing control signals for controlling the integrated driver 610 and the data driver board 620.

The control board 630 supplies a timing control signal for the scan electrode Y and a timing control signal for the sustain electrode Z to the integrated driver 610 through a conductive film element 631. Further, the control board 630 supplies a timing control signal for the address electrode X to the data driver board 620 through a conductive film element 632.

The power supply board (not shown) supplies power to each of the integrated driver 610, the data driver board 620, and the control board 630.

The integrated driver 710, the data driver board 620, the control board 630, and the power supply board are fixed on the frame 600 using a plurality of bosses (not shown).

The frame 600 is positioned to overlap the rear surface of the plasma display panel 640, thereby emitting heat generated in the plasma display panel 640 and the integrated driver 610, the data driver board 620, and the control board 630 to the outside. Further, the frame 600 serves as a ground part of each of the integrated driver 610, the data driver board 620, and the control board 630, thereby stabilizing driving of the plasma display apparatus.

The foregoing embodiments and advantages are merely exemplary and are not to be construed as limiting the present invention. The present teaching can be readily applied to other types of apparatuses. The description of the foregoing embodiments is intended to be illustrative, and not to limit the scope of the claims. Many alternatives, modifications, and variations will be apparent to those skilled in the art.

## Claims

1. A plasma display apparatus comprising:
a plasma display panel including a scan electrode and a sustain electrode;
an integrated driver that supplies a driving signal to the scan electrode and the sustain electrode;
a frame positioned between the plasma display panel and the integrated driver; and
a conductive film element that is positioned between the plasma display panel and the frame, and electrically connects the integrated driver to the sustain electrode.

2. The plasma display apparatus of claim 1, further comprising a conductive layer positioned between the plasma display panel and the frame,
wherein the conductive layer is connected to a conductive film element connected to the sustain electrode and a conductive film element connected to the integrated driver.

3. The plasma display apparatus of claim 2, wherein the conductive layer is positioned in an area corresponding to an effective screen of the plasma display panel.

4. The plasma display apparatus of claim 3, wherein the conductive layer is a conductive tape.

5. The plasma display apparatus of claim 3, wherein the conductive layer is formed by depositing a conductive material on an adhesive sheet.

6. The plasma display apparatus of claim 1, wherein the integrated driver supplies a sustain signal, that swings between a positive sustain voltage and a negative sustain voltage, to the scan electrode, and supplies a ground level voltage to the sustain electrode during a sustain period.

7. The plasma display apparatus of claim 1, wherein the conductive film element is a flexible printed circuit (FPC).

8. A plasma display apparatus comprising:
a plasma display panel including a scan electrode and a sustain electrode;
an integrated driver that supplies a driving signal to the scan electrode and the sustain electrode;
a frame positioned between the plasma display panel and the integrated driver;
a conductive film element that is positioned on the frame, and electrically connects the integrated driver to the sustain electrode; and
a fixing element that is positioned on the frame, and fixes the conductive film element on the frame.

9. The plasma display apparatus of claim 8, wherein the frame adheres to the conductive film element through the fixing element.

10. The plasma display apparatus of claim 8, wherein the fixing element includes an insulating material.

11. The plasma display apparatus of claim 10, wherein the fixing element includes an adhesive tape.

12. The plasma display apparatus of claim 10, wherein the fixing element is a mold wrapping the conductive film element.

13. The plasma display apparatus of claim 12, wherein the mold is formed of plastic.

14. The plasma display apparatus of claim 8, wherein the integrated driver supplies a sustain signal, that swings between a positive sustain voltage and a negative sustain voltage, to the scan electrode, and supplies a ground level voltage to the sustain electrode during a sustain period.

15. The plasma display apparatus of claim 8, wherein the conductive film element is a flexible printed circuit (FPC).
